# FASCICULE DE BREVET EUROPEEN

(11) **EP 2 845 237 B1**
(45) Date de publication et mention de la délivrance du brevet: **06.09.2017**
(21) Numéro de dépôt: 13725397.7
(22) Date de dépôt: 30.04.2013
(51) Int. Cl.: H01L 41/08, G10K 11/18, B32B 17/10

(54) **SUBSTRAT TRANSPARENT COMPRENANT AU MOINS UN ÉLÉMENT PIÉZOÉLECTRIQUE, VITRAGE ISOLANT COMPRENANT LE SUBSTRAT ET UTILISATION DU SUBSTRAT OU DU VITRAGE**
TRANSPARENTES SUBSTRAT MIT MINDESTENS EINEM PIEZOELEKTRISCHEN ELEMENT, ISOLIERVERGLASUNG MIT DEM SUBSTRAT SOWIE VERWENDUNG DES SUBSTRATES ODER DER VERGLASUNG
TRANSPARENT SUBSTRATE COMPRISING AT LEAST ONE PIEZOELECTRIC ELEMENT, INSULATING GLAZING COMPRISING THE SUBSTRATE AND USE OF THE SUBSTRATE OR GLAZING

(30) Priorité: 03.05.2012 FR 1254039
(43) Date de publication de la demande: 11.03.2015
(73) Titulaire: Saint-Gobain Glass France, 92400 Courbevoie (FR)
(72) Inventeur: LEYDER, Charles, F-75019 Paris (FR); MOREAU, Virginie, F-75018 Paris (FR); RUCHMANN-EPOUSE STERNCHUSS, Juliette, F-78100 Saint German en Laye (FR); SOON, Jia Mei, 94240 L'hay les roses (FR); PYTHON, Martin, CH-1483 Vesin (CH); LAMINE, Driss, F-92160 Antony (FR); VERGER, Arnaud, F-75013 Paris (FR)
(74) Mandataire: Saint-Gobain Recherche
(86) Numéro de dépôt international: PCT/FR2013/050952
(87) Numéro de publication internationale: WO 2013/164540

(56) Documents cités:
- WO-A1-97/16817
- US-A1- 2007 081 681

## Description

L'invention concerne un substrat transparent comprenant au moins un élément piézoélectrique.

Il est connu de faire vibrer un substrat transparent en lui transmettant une onde mécanique. Une solution existante consiste à appliquer une tension électrique aux bornes d'un ou plusieurs transducteurs piézoélectriques massifs collés sur la surface du substrat transparent. Toutefois, ces transducteurs sont nécessairement disposés sur le pourtour du substrat transparent pour ne pas gêner la vue à travers un vitrage comprenant le substrat transparent. Or, dans ces conditions, il est difficile de contrôler les vibrations du substrat transparent.

Il y a donc un besoin pour un substrat transparent comprenant au moins un élément piézoélectrique qui ne gêne pas la vue à travers un vitrage comprenant le substrat transparent et qui permette un contrôle précis des vibrations du substrat transparent.

Les documents WO97/16817 et US2007/081681 sont des exemples de l'art antérieur. Pour cela, l'invention propose un substrat transparent comprenant sur au moins une de ses faces au moins un élément piézoélectrique transparent, chaque élément piézoélectrique étant situé entre une première et une deuxième électrodes transparentes, et chaque élément piézoélectrique et les première et deuxième électrodes transparentes sont sous forme de couches, de façon à former au moins un transducteur piézoélectrique transparent, et au moins une couche diélectrique est disposée entre chaque première et deuxième électrode transparente et le ou les éléments piézoélectriques transparents. Selon une autre particularité, l'élément piézoélectrique transparent et les première et deuxième électrodes transparentes sont chacun(e) sous forme d'une couche disposée sur toute la surface du substrat transparent et forment un unique transducteur piézoélectrique transparent.

Selon une autre particularité, le ou les éléments piézoélectriques transparents et les première et deuxième électrodes transparentes sont disposés de façon à former une pluralité de transducteurs piézoélectriques transparents répartis de façon matricielle sur la surface du substrat transparent.

Selon une autre particularité, le substrat transparent comprend :
- une première électrode transparente sous forme d'une couche disposée sur toute la surface du substrat transparent,
- une pluralité d'éléments piézoélectriques transparents sous forme d'une pluralité de portions de couche réparties de façon matricielle sur la surface du substrat transparent, les éléments piézoélectriques transparents étant isolés les uns des autres par un matériau isolant,
- une pluralité de deuxièmes électrodes transparentes sous forme d'une pluralité de portions de couche réparties de façon matricielle, chaque deuxième électrode transparente étant disposée sur un seul élément piézoélectrique transparent.

Selon une autre particularité, le substrat transparent comprend :
- une pluralité de premières électrodes transparentes sous forme d'une pluralité de portions de couche réparties de façon matricielle sur la surface du substrat transparent,
- un élément piézoélectrique transparent sous forme d'une couche disposée sur toute la surface du substrat transparent,
- une deuxième électrode transparente sous forme d'une couche disposée sur toute la surface du substrat transparent.

Selon une autre particularité, le substrat transparent comprend :
- une pluralité de premières électrodes transparentes sous forme de lignes de couche,
- un élément piézoélectrique transparent sous forme d'une couche disposée sur toute la surface du substrat transparent,
- une pluralité de deuxièmes électrodes transparentes sous forme de lignes de couche.

Selon une autre particularité, chaque élément piézoélectrique transparent est en polyfluorure de vinylidène ou en Titano-Zirconate de Plomb dopé au Lanthane (PLZT) ou en oxyde de zinc ou en nitrure d'aluminium ou en copolymère à bloc de poly(styrène-b-isoprène) ou en oxyde de titane et de baryum de type Ba-TiO₃.

Selon une autre particularité, le substrat transparent est en verre organique ou inorganique.

Selon une autre particularité, chaque première et deuxième électrode transparente est reliée à un potentiel donné.

Selon une autre particularité, les première et deuxième électrodes transparentes sous forme de couche sont constituées d'un empilement de couches minces comprenant au moins une couche mince en oxyde transparent conducteur et/ou une couche mince métallique et dans lequel chaque élément piézoélectrique transparent est sous forme d'une couche mince.

L'invention concerne également un vitrage isolant comprenant :
- au moins deux substrats transparents espacés deux à deux par une lame de gaz, au moins un des substrats transparents étant tel que décrit plus haut,
- le ou les transducteurs piézoélectriques transparents étant adaptés à être connectés électriquement à un dispositif électronique adapté à recevoir et analyser un signal émis par le ou les transducteurs piézoélectriques transparents soumis à une ou des vibrations et/ou à envoyer un signal à l'élément ou aux transducteurs piézoélectriques transparents de façon à faire vibrer un des substrats transparents.

Selon une autre particularité, au moins une face du ou des substrats transparents comprenant au moins un élément piézoélectrique transparent est tournée vers la lame de gaz.

Selon une autre particularité, lorsque deux substrats transparents comprennent chacun au moins un élément piézoélectrique transparent ou lorsque les deux faces d'un même substrat comprennent chacune au moins un élément piézoélectrique transparent, le nombre et la répartition des transducteurs piézoélectriques transparents sur la surface des deux substrats transparents ou sur les deux faces du substrat transparent est identique.

L'invention concerne également une utilisation du substrat transparent décrit plus haut ou du vitrage isolant décrit plus haut pour nettoyer de la poussière ou de l'eau sur le ou les substrats transparents comprenant au moins un élément piézoélectrique transparent par envoi d'un signal par le dispositif électronique à le ou les transducteurs piézoélectriques du ou des substrats transparents de façon à faire vibrer le ou les substrats transparents et faire tomber la poussière ou l'eau du ou des substrats transparents.

L'invention concerne également une utilisation du substrat transparent décrit plus haut ou du vitrage isolant décrit plus haut comme haut-parleur par transmission d'un signal par le dispositif électronique à le ou les transducteurs piézoélectriques d'un substrat transparent comprenant au moins un élément piézoélectrique transparent de façon à faire vibrer le substrat transparent et à diffuser un signal audible.

L'invention concerne également une utilisation du substrat transparent décrit plus haut ou du vitrage isolant décrit plus haut comme microphone par transformation des vibrations d'un substrat transparent comprenant au moins un élément piézoélectrique transparent, les vibrations étant produites sous l'effet d'un signal audible et transformées par le ou les transducteurs piézoélectriques en impulsions électriques destinées à être enregistrées.

L'invention concerne également une utilisation du substrat transparent décrit plus haut ou du vitrage isolant décrit plus haut comme générateur électrique par transformation des vibrations d'un substrat transparent comprenant au moins un élément piézoélectrique transparent, les vibrations étant produites sous l'effet de sollicitations mécaniques et transformées par le ou les transducteurs piézoélectriques en un signal électrique pour la production d'électricité.

L'invention concerne également une utilisation du substrat transparent décrit plus haut ou du vitrage isolant décrit plus haut pour atténuer ou, respectivement, amplifier des sons venant de l'extérieur ou de l'intérieur d'un bâtiment sur lequel est posé le substrat transparent ou le vitrage par réception et analyse par un dispositif électronique d'un premier signal émis par le ou les transducteurs piézoélectriques transparents d'un substrat transparent comprenant au moins un élément piézoélectrique transparent et envoi par le dispositif électronique d'un deuxième signal, en opposition de phase ou, respectivement en accord de phase, avec le premier signal, à le ou aux transducteurs piézoélectriques transparents dudit substrat transparent ou à le ou les transducteurs piézoélectriques transparents d'un autre substrat transparent du vitrage dans le cas d'un vitrage comprenant au moins deux substrats transparents comprenant au moins un élément piézoélectrique transparent.

Kit comprenant le substrat transparent décrit plus haut ou le vitrage isolant décrit plus haut et un dispositif électronique adapté à recevoir et analyser un signal émis par le ou les transducteurs piézoélectriques transparents d'au moins un substrat transparent comprenant au moins un élément piézoélectrique transparent et/ou à envoyer un signal à le ou les transducteurs piézoélectriques transparents d'au moins un substrat transparent comprenant au moins un élément piézoélectrique transparent de façon à faire vibrer un des substrats transparents du vitrage isolant et/ou à enregistrer un signal électrique émis par le ou les transducteurs piézoélectriques transparents du ou des substrats transparents en réponse à des vibrations du substrat.

D'autres caractéristiques et avantages de l'invention vont à présent être décrits en regard des dessins sur lesquels :
- La figure 1 représente une vue schématique en coupe transversale d'un substrat transparent selon un premier mode de réalisation de l'invention ;
- La figure 2 représente une vue schématique de face d'un substrat transparent selon un deuxième mode de réalisation de l'invention ;
- La figure 3 représente une vue schématique en coupe transversale d'un premier exemple de substrat transparent selon le deuxième mode de réalisation, selon l'axe A-A de la figure 2 ;
- La figure 4 représente une vue schématique de face d'un deuxième exemple de substrat transparent selon le deuxième mode de réalisation de l'invention ;
- La figure 5 représente une vue schématique en coupe transversale du substrat transparent de la figure 4 selon l'axe A-A ;
- La figure 6 représente une vue schématique de face d'un troisième exemple de substrat transparent selon le deuxième mode de réalisation de l'invention ;
- La figure 7 représente une vue schématique en coupe transversale du substrat transparent de la figure 6 selon l'axe A-A ;
- La figure 8 représente une vue schématique de face d'un quatrième exemple de substrat transparent selon le deuxième mode de réalisation de l'invention ;
- Les figures 9a et 9b représentent une vue schématique en coupe transversale du substrat transparent de la figure 8 respectivement selon l'axe A-A et selon l'axe B-B.

Les numéros de référence qui sont identiques sur les différentes figures représentent des éléments similaires ou identiques.

Un substrat transparent est défini comme un substrat à fonction verrière, notamment en verre sodo-calcique ou en plastique par exemple de type polyéthylène téréphtalate (PET), polyéthylène naphtalate (PEN), polycarbonate (PC), polyméthylmétacrylate (PMMA) ou encore poly(éthylène-co-tetrafluoroéthylène) (ETFE).

Le terme « transparent » définit une transmission totale (directe et diffuse) supérieure à 1%, et de préférence supérieure à 40 %, pour des longueurs d'onde visibles de l'oeil humain, à partir d'un spectre composé de raies discrètes et/ou continues. Ces longueurs d'onde visibles sont comprises entre 350 et 800 nm.

Un transducteur piézoélectrique est constitué d'un matériau piézoélectrique et est adapté à transformer un mouvement mécanique tel que des vibrations en un signal électrique et vice versa.

L'invention se rapporte à un substrat transparent comprenant sur au moins une de ses faces au moins un élément piézoélectrique transparent situé entre deux électrodes transparentes. Le ou les éléments piézoélectriques et les électrodes transparentes sont sous forme de couches. Le ou les éléments piézoélectriques et les électrodes transparentes sont disposés de façon à former au moins un transducteur piézoélectrique transparent.

Ainsi, un tel substrat transparent, qui ne comporte que des éléments transparents, permet de ne pas gêner la vue ou la transmission lumineuse à travers un vitrage comprenant un tel substrat transparent. Le ou les transducteurs piézoélectriques peuvent être disposés n'importe où sur la surface du substrat transparent, ce qui permet de contrôler de façon bien plus efficace les vibrations du substrat transparent.

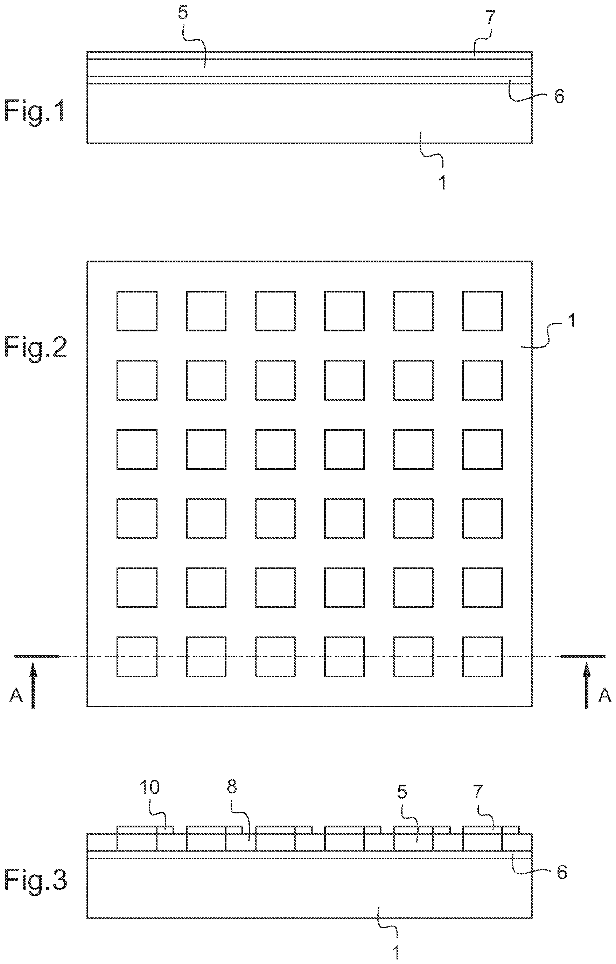

La figure 1 représente une vue schématique d'un substrat transparent selon un premier mode de réalisation de l'invention.

Le substrat transparent 1 comporte sur une de ses faces une première électrode transparente 6, surmontée d'une couche piézoélectrique transparente 5, elle-même surmontée d'une deuxième électrode transparente 7.

Les première et deuxième électrodes transparentes 6, 7 et la couche piézoélectrique transparente 5 sont chacune sous forme d'une couche déposée sur toute la surface du substrat transparent 1. La couche (piézoélectrique ou électrodes) est de préférence une couche mince. Les électrodes peuvent, en variante, être déposées par dépôt liquide ou par sol-gel.

La couche piézoélectrique transparente 5 est destinée à être électriquement connectée, via les première et deuxième électrodes transparentes 6, 7, à un dispositif électronique adapté à recevoir et analyser un signal reçu par le ou les éléments piézoélectriques transparents 5 et/ou à envoyer un signal via le ou les éléments piézoélectriques transparents 5 et/ou à enregistrer un signal électrique émis par le ou les éléments piézoélectriques transparents 5. La couche piézoélectrique joue le rôle d'un transducteur piézoélectrique. Le fait qu'elle soit répartie sur toute la surface du substrat permet de mieux analyser et/ou contrôler les vibrations du substrat.

Les électrodes transparentes 6, 7 sont de préférence constituées d'un empilement de couches minces comprenant au moins une couche mince en oxyde transparent conducteur et/ou une couche mince métallique. L'épaisseur des électrodes transparentes 6, 7 est comprise entre 10 et 500 nm. La résistance par carré des électrodes transparentes 6, 7 est de préférence inférieure ou égale à 500 Ω/□, voire inférieure ou égale à 100Ω/□, voire inférieure ou égale à 50 Ω/□.

Le ou les éléments piézoélectriques transparents 5 sont par exemple en polyfluorure de vinylidène ou en Titano-Zirconate de Plomb (PbO - ZrO₂ - TiO₂) dopé au Lanthane (PLZT) ou en oxyde de zinc ou en nitrure d'aluminium ou en copolymère à bloc de poly(styrène-b-isoprène) ou en oxyde de titane et de baryum de type BaTiO₃ L'épaisseur de chaque élément piézoélectrique est comprise entre 1 nm et 10 µm, de préférence entre 0,5 et 5 µm.

En fonctionnement, chaque électrode transparente 6, 7 est à un potentiel différent. Par exemple, une électrode est à la masse et l'autre électrode est à un potentiel différent de celui de la masse. La couche piézoélectrique forme alors un transducteur piézoélectrique unique réparti sur toute la surface du substrat.

La figure 2 représente une vue schématique d'un substrat transparent selon un deuxième mode de réalisation de l'invention. Dans ce mode de réalisation, le substrat transparent 1 comporte une pluralité de transducteurs piézoélectriques transparents, représentés par des cellules carrées sur la figure 2, et disposés de façon matricielle. Le fait d'avoir une pluralité de transducteurs piézoélectriques répartis de façon matricielle permet de connecter électriquement chaque transducteur piézoélectrique indépendamment les uns des autres à un dispositif électronique. En particulier, chaque transducteur piézoélectrique transparent est entre deux électrodes transparentes et est soumis à une différence de potentiel. De préférence, cette différence de potentiel est différente pour chaque transducteur piézoélectrique. Cela permet ainsi de recevoir ou d'envoyer un signal avec de nombreuses harmoniques, donc un signal beaucoup plus précis que pour un transducteur piézoélectrique selon le mode de réalisation de la figure 1. Le fait que les transducteurs piézoélectriques soient répartis sur toute la surface du substrat permet également d'analyser et/ou de contrôler de façon très précise les vibrations du substrat.

Chaque transducteur piézoélectrique transparent peut être réalisé de diverses façons. Les figures 3 à 9 montrent différents exemples de réalisation du mode de réalisation de la figure 2. Dans l'ensemble de ces figures, les matériaux et les épaisseurs des éléments piézoélectriques transparents 5 et des électrodes transparentes 6, 7 sont identiques à ce qui a été décrit pour le premier mode de réalisation de la figure 1.

La figure 3 représente une vue schématique en coupe transversale d'un premier exemple de substrat transparent selon le deuxième mode de réalisation, selon l'axe A-A de la figure 2.

Dans ce premier exemple, le substrat transparent 1 comprend une première électrode transparente 6 sous forme d'une couche répartie sur toute la surface du substrat, de préférence sous forme d'une couche mince. Cette première électrode transparente 6 est adaptée à être connectée à un dispositif électronique. En fonctionnement, la première électrode transparente 6 est à un potentiel donné, de préférence à la masse.

Sur cette première électrode transparente 6, le substrat transparent 1 comprend une pluralité d'éléments piézoélectriques transparents 5 répartis de façon matricielle. Les éléments piézoélectriques transparents 5 sont sous forme de portions de couche piézoélectrique, de préférence sous forme de portions de couche mince. Les éléments piézoélectriques transparents 5 sont séparés les uns des autres par un matériau 8 isolant électriquement.

Au-dessus de chaque élément piézoélectrique, le substrat transparent 1 comprend une deuxième électrode transparente 7. Il y a ainsi une pluralité de deuxièmes électrodes transparentes 7 réparties de façon matricielle. Chaque deuxième électrode transparente 7 recouvre la surface d'un seul élément piézoélectrique transparent 5 et est reliée par un connecteur électrique transparent 10 au bord du substrat. Chaque connecteur électrique transparent 10 permet une connexion électrique de chaque deuxième électrode transparente 7 au dispositif électronique. Chaque connecteur électrique transparent 10 est sur le matériau isolant afin d'être isolé des éléments piézoélectriques. En fonctionnement, chaque deuxième électrode transparente 7 est à un potentiel donné, différent de celui de la masse si la première électrode transparente 6 est à la masse. Chaque connecteur électrique transparent 10 est de préférence dans le même matériau et a de préférence la même épaisseur que les deuxièmes électrodes transparentes 7, ce qui permet de simplifier la fabrication du substrat. Les éléments piézoélectriques, le matériau isolant et les deuxièmes électrodes sont par exemple déposés par sérigraphie, à l'aide d'un masque. Les figures ne sont pas du tout à l'échelle. De préférence, les connecteurs électriques transparents 10 sont très fins.

Dans la configuration de la figure 3, chaque élément piézoélectrique transparent 5 forme un transducteur piézoélectrique.

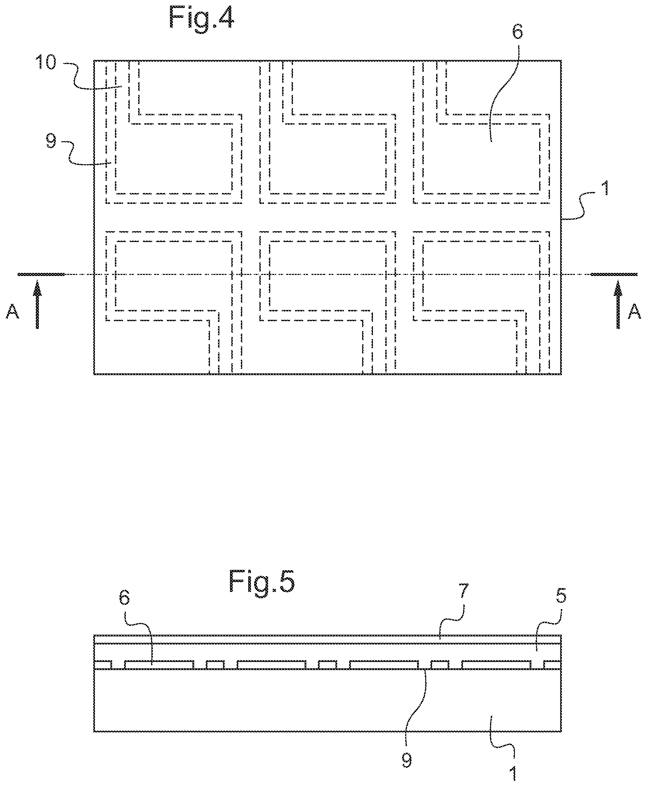

Les figures 4 et 5 représentent une vue schématique d'un deuxième exemple de substrat transparent selon le deuxième mode de réalisation.

Dans ce deuxième exemple, le substrat transparent 1 comprend une pluralité de premières électrodes transparentes 6 réparties de façon matricielle sur la surface du substrat 1. Pour faciliter la fabrication du substrat, une couche en matériau des premières électrodes transparentes 6 peut être déposée sur toute la surface du substrat et chaque première électrode 6 peut être isolée du reste de la couche par une rainure 9 entourant chaque électrode et ayant l'épaisseur de la couche. Chaque première électrode transparente 6 est reliée au bord du substrat transparent 1 par un connecteur électrique transparent 10. Chaque rainure 9 peut, pour faciliter la fabrication du substrat, entourer à la fois une première électrode transparente 6 et son connecteur électrique transparent 10. Chaque rainure 9 peut être réalisée par exemple par gravure laser, par sérigraphie, à l'aide d'un masque ou encore par photolithographie. Ces rainures sont de préférence suffisamment fines pour ne pas gêner la vue. Les figures ne sont pas du tout à l'échelle. De préférence, les connecteurs électriques transparents 10 sont très fins.

Chaque première électrode transparente 6 est surmontée d'une couche piézoélectrique transparente 5 disposée sur toute la surface du substrat transparent 1, elle-même surmontée d'une deuxième électrode transparente 7, également sous forme d'une couche disposée sur toute la surface du substrat transparent 1. Chaque rainure 9 est alors, après le dépôt de la couche piézoélectrique, remplie du matériau de la couche piézoélectrique, qui est un isolant électrique, ce qui garantit l'isolation électrique des premières électrodes transparentes 6 les unes par rapport aux autres.

En fonctionnement, la deuxième électrode transparente 7 est de préférence à la masse et chaque première électrode transparente 6 est à un potentiel donné, différent de celui de la masse si la deuxième électrode transparente 7 est à la masse. Dans la configuration des figures 4 et 5, le substrat transparent 1 comporte une pluralité de transducteurs piézoélectriques transparents aux endroits où sont les premières électrodes transparentes 6.

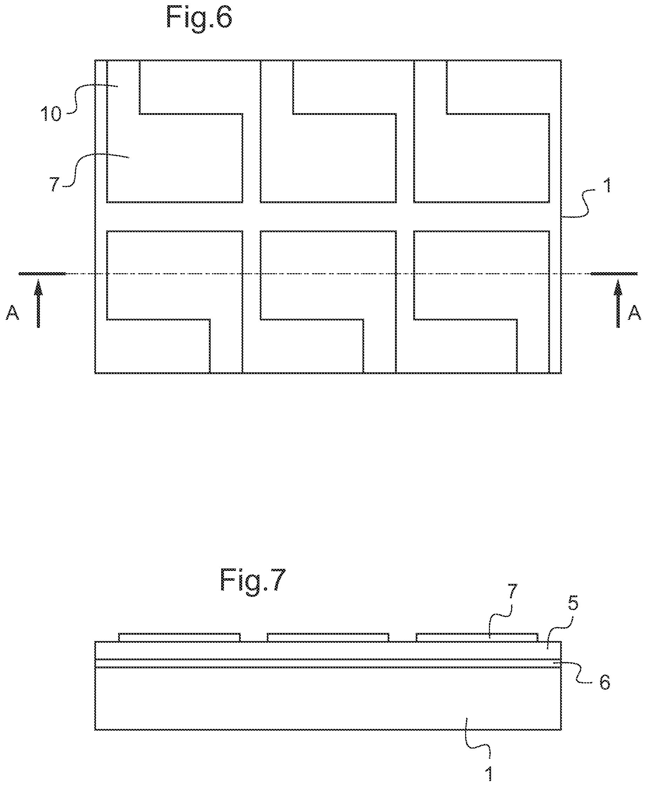

Les figures 6 et 7 représentent une vue schématique d'un troisième exemple de substrat transparent selon le deuxième mode de réalisation.

Dans ce troisième exemple, le substrat transparent 1 comprend, au moins sur une de ses faces, une première électrode transparente 6 sous forme d'une couche disposée sur toute la surface du substrat transparent 1. La première électrode transparente 6 est surmontée d'une couche piézoélectrique transparente 5, également disposée sur toute la surface du substrat transparent 1. La couche piézoélectrique transparente 5 est surmontée d'une pluralité de deuxièmes électrodes transparentes 7 réparties de façon matricielle sur la surface du substrat 1. Chaque deuxième électrode transparente 7 est reliée au bord du substrat transparent 1 par un connecteur électrique transparent 10. Les deuxièmes électrodes transparentes 7 et les connecteurs électriques transparents 10 sont par exemple réalisés par sérigraphie ou à l'aide d'un masque. Les figures ne sont pas du tout à l'échelle. En réalité, les connecteurs électriques transparents 10 sont très fins.

En fonctionnement, la première électrode transparente 6 est de préférence à la masse et chaque deuxième électrode transparente 7 est à un potentiel donné, différent de celui de la masse si la première électrode transparente 6 est à la masse. Dans la configuration des figures 6 et 7, le substrat transparent 1 comprend une pluralité de transducteurs piézoélectriques transparents aux endroits où sont les deuxièmes électrodes transparentes 7.

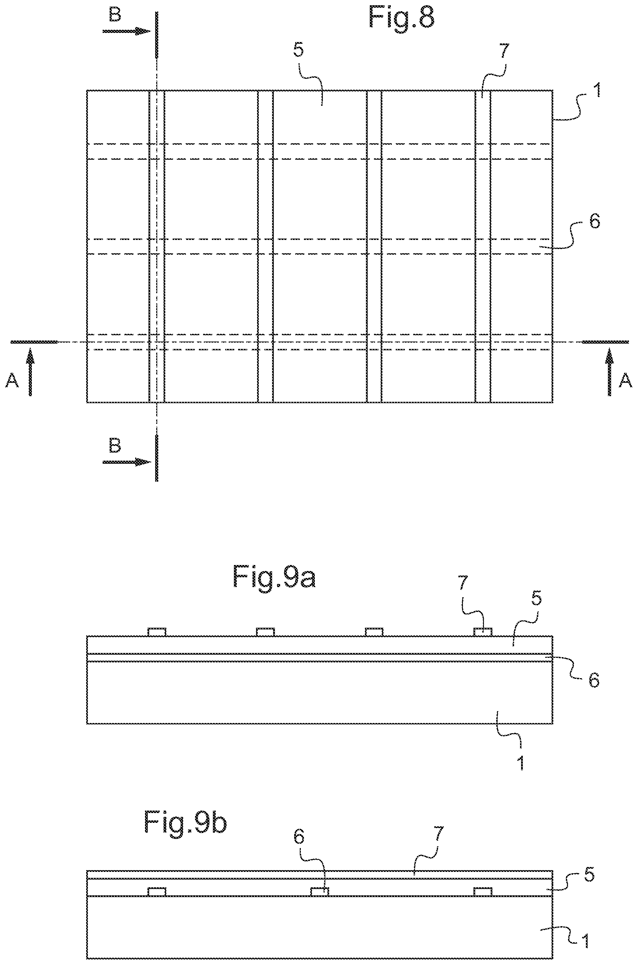

Les figures 8, 9a et 9b représentent une vue schématique d'un quatrième exemple de substrat transparent selon le deuxième mode de réalisation.

Dans ce quatrième exemple, le substrat transparent 1 comprend une pluralité de premières électrodes transparentes 6 sous forme de lignes parallèles les unes aux autres, disposées sur toute la surface du substrat transparent 1. Les premières électrodes transparentes 6 sont réalisées par exemple par gravure laser, par sérigraphie, à l'aide d'un masque ou encore par photolithographie.

Les premières électrodes transparentes 6 sont surmontées d'une couche piézoélectrique transparente 5, disposée sur toute la surface du substrat transparent 1. Du matériau de la couche piézoélectrique, qui est un isolant électrique, remplit alors l'espace entre deux lignes adjacentes, ce qui garantit l'isolation électrique des premières électrodes transparentes 6 les unes par rapport aux autres.

La couche piézoélectrique transparente 5 est surmontée d'une pluralité de deuxièmes électrodes transparentes 7 sous forme de colonnes parallèles les unes aux autres, disposées sur toute la surface du substrat transparent 1. Les deuxièmes électrodes transparentes 7 sont par exemple réalisées par sérigraphie ou à l'aide d'un masque.

Chaque première et chaque deuxième électrode transparente 6, 7 est disposée entre deux bords opposés du substrat transparent 1. En fonctionnement, chaque première électrode transparente 6 et chaque deuxième électrode transparente 7 est à un potentiel donné, de préférence différent de celui de la masse. Dans la configuration des figures 8, 9a et 9b, le substrat transparent 1 comprend une pluralité de transducteurs piézoélectriques transparents aux intersections entre les premières et les deuxièmes électrodes transparentes 6, 7.

Dans l'ensemble des modes de réalisation, le substrat peut comprendre un ou des transducteurs piézoélectriques sur une seule de ses faces ou sur ses deux faces.

Le substrat transparent selon tous les modes de réalisation de l'invention peut être utilisé dans un vitrage simple ou dans un vitrage multiple ou isolant.

Un vitrage multiple ou isolant selon l'invention comprend au moins deux substrats transparents et un cadre espaceur disposé entre deux substrats transparents adjacents, à proximité des bords des substrats transparents. Le cadre espaceur permet de maintenir un écartement entre les substrats transparents. L'espace entre les deux substrats transparents, appelé lame d'air ou lame de gaz, est rempli d'air ou de gaz rare.

Le vitrage isolant selon l'invention peut comprendre un seul substrat transparent comprenant au moins un élément piézoélectrique transparent ou au moins deux substrats transparents comprenant au moins un élément piézoélectrique transparent sur au moins l'un des deux substrats. Dans le cas où plusieurs substrats transparents du vitrage isolant comprennent chacun une pluralité d'éléments piézoélectriques transparents ou dans le cas où les deux faces d'un même substrat comprennent chacune au moins un élément piézoélectrique transparent, le nombre et la répartition géographique des éléments piézoélectriques transparents sur la surface des différents substrats transparents ou sur les deux faces du même substrat transparent sont de préférence identiques. De même, la face du ou des substrats transparents 1 comprenant au moins un élément piézoélectrique transparent 5 (dans le cas où les transducteurs piézoélectriques ne sont que sur une face du substrat) est de préférence tournée vers la lame de gaz.

Les électrodes transparentes 6, 7 du substrat transparent 1 sont destinées à être électriquement connectées à un dispositif électronique adapté à recevoir et analyser et/ou envoyer un signal électrique.

Dans l'ensemble des modes de réalisation, chaque substrat transparent 1 peut comporter au moins une couche isolante entre chaque électrode transparente 6, 7 et le ou les éléments piézoélectriques transparents 5. Les couches isolantes permettent de prévenir tout court-circuit entre les deux électrodes 6, 7. En effet, en l'absence de couches isolantes, un court-circuit pourrait survenir du fait de grains de poussière, d'arcs pendant le dépôt des couches minces ou encore de défauts du substrat ou des éléments piézoélectriques. Or, un court-circuit est nuisible au système car il entraîne une diminution de l'effet piézoélectrique.

Ainsi, de préférence, au moins une couche isolante est disposée entre l'électrode transparente 6 et le ou les éléments piézoélectriques transparents 5 et/ou au moins une couche isolante est disposée entre l'électrode transparente 7 et le ou les éléments piézoélectriques transparents 5. De manière préférée, au moins deux couches isolantes, voire au moins trois couches isolantes, sont disposées entre l'électrode transparente 6 et le ou les éléments piézoélectriques transparents 5 et/ou au moins deux couches isolantes, voire au moins trois couches isolantes, sont disposées entre l'électrode transparente 7 et le ou les éléments piézoélectriques transparents 5. Lorsqu'il y a au moins deux couches isolantes superposées, ces couches sont en matériau différent. De plus, lorsqu'il y a au moins deux couches isolantes superposées, il y a de préférence une alternance couche amorphe/couche cristalline. En outre, les couches isolantes situées au-dessus et en dessous du ou des éléments piézoélectriques peuvent être de matériaux différents.

Chaque couche isolante est une couche diélectrique, qui peut être déposée par sol-gel, ALD, CVD, pulvérisation magnétron, ou encore PECVD. Chaque couche isolante est par exemple en SiO₂, TiO₂, SiN, AIN, HfO₂, Al₂O₃, Y₂O₃, SiON, ZrO₂, Ta₂O₅, SnO₂, ou encore SnZnOₓ. Les couches isolantes peuvent également être en une combinaison de ces matériaux, déposés successivement ou simultanément.

Par ailleurs, pour éviter une perte significative de tension dans le ou les éléments piézoélectriques, il est nécessaire que l'épaisseur des couches isolantes soit la plus faible possible. Ainsi, l'épaisseur de l'ensemble des couches isolantes situées entre une électrode transparente 6, 7 et le ou les éléments piézoélectriques transparents 5 est inférieure à 30% de l'épaisseur du ou des éléments piézoélectriques, de préférence inférieure à 10% de l'épaisseur du ou des éléments piézoélectriques transparents 5.

De surcroît, la ou les couches isolantes, en matériau diélectriques, permettent d'anti-refléter les couches minces des électrodes transparentes 6, 7.

Par ailleurs, dans l'ensemble des modes de réalisation, chaque substrat transparent 1 est en verre organique ou inorganique. L'épaisseur de chaque substrat transparent 1 est comprise entre 10 µm et 10 mm, de préférence entre 10 µm et 500 µm pour un verre organique et de préférence entre 500 µm et 5 mm, voire entre 1 mm et 3 mm pour un verre inorganique.

Le taux de couverture d'une surface du substrat transparent 1 par des transducteurs piézoélectrique (nombre et surface des transducteurs) est à adapter en fonction de la surface et de l'épaisseur du verre, ainsi qu'en fonction de l'application visée.

Le vitrage simple ou le vitrage multiple selon l'invention peut être utilisé pour différentes applications comme, par exemple, nettoyer de la poussière ou de l'eau sur le substrat transparent, ou encore pour diffuser un signal sonore en jouant le rôle d'un haut-parleur, ou encore pour jouer le rôle d'un microphone, ou encore pour générer de l'électricité.

Ainsi, si un seul substrat transparent 1 du vitrage isolant est muni d'au moins un élément piézoélectrique transparent, seul ce substrat est susceptible de vibrer via l'envoi d'un signal adapté par le dispositif électronique à le ou les transducteurs piézoélectriques transparents via les électrodes transparentes 6, 7, ou encore de produire un signal électrique via les transducteurs piézoélectriques transparents 5 transmis au dispositif électronique par les électrodes transparentes 6, 7.

Si au moins deux substrats transparents 1 du vitrage isolant sont chacun munis d'au moins un élément piézoélectrique transparent, les différents substrats sont tous susceptibles de vibrer via l'envoi d'un signal adapté par le dispositif électronique à le ou les transducteurs piézoélectriques transparents via les électrodes transparentes 6, 7, ou encore de produire un signal électrique via les transducteurs piézoélectriques transparents 5 transmis au dispositif électronique par les électrodes transparentes 6, 7.

L'atténuation acoustique peut concerner des bruits provenant de l'extérieur d'un bâtiment sur lequel est monté le vitrage isolant ou d'une pièce équipée d'un substrat transparent selon l'invention, bruits que l'on cherche à ne pas entendre à l'intérieur, ou encore pour atténuer des bruits produits à l'intérieur du bâtiment ou de la pièce pour qu'ils ne soient pas transmis vers l'extérieur du bâtiment. Pour ce faire, les vibrations du substrat dues aux bruits sont transmises mécaniquement à le ou aux transducteurs piézoélectriques transparents et sont détectées par le ou les transducteurs piézoélectriques transparents disposés sur le substrat. Les vibrations sont transformées en un signal électrique sous forme d'impulsions électriques par le ou les transducteurs piézoélectriques transparents. Le signal électrique produit est reçu par le dispositif électronique qui l'analyse et envoie à le ou aux transducteurs piézoélectriques transparents du même substrat (dans le cas d'un vitrage simple ou d'un vitrage multiple équipé d'un seul substrat comprenant au moins un élément piézoélectrique) ou d'un autre substrat (dans le cas d'un vitrage multiple équipé d'au moins deux substrats comprenant au moins un élément piézoélectrique) un signal en opposition de phase avec le signal reçu de façon à annuler le bruit. Dans le cas d'un vitrage équipé de deux substrats selon l'invention, les bruits peuvent être détectés par les transducteurs piézoélectriques disposés sur le substrat côté bruit et atténués par les transducteurs piézoélectriques disposés sur le substrat opposé. Dans le cas d'un substrat dont les deux faces comprennent des transducteurs piézoélectriques, les bruits peuvent être détectés par les transducteurs piézoélectriques disposés sur la face du substrat située côté bruit et atténués par les transducteurs piézoélectriques disposés sur la face du substrat opposée.

L'amplification acoustique fonctionne de la même façon, avec un signal envoyé par le dispositif électronique qui est en accord de phase et non en opposition de phase.

Dans le cas d'un vitrage équipé de deux substrats selon l'invention, le système peut être réversible, en atténuant au choix des bruits provenant de l'extérieur ou de l'intérieur.

Le nettoyage de la poussière ou de l'eau sur un substrat transparent comprenant au moins un élément piézoélectrique est réalisé par envoi d'un signal électrique par le dispositif électronique à le ou les transducteurs piézoélectriques transparents du ou des substrats transparents. Le ou les transducteurs piézoélectriques transparents transforment le signal électrique en vibrations de façon à faire vibrer le ou les substrats transparents et faire tomber la poussière ou l'eau du ou des substrats transparents.

L'utilisation d'un substrat comprenant au moins un élément piézoélectrique comme haut-parleur est réalisée par transmission d'un signal électrique par le dispositif électronique à le ou les transducteurs piézoélectriques du substrat transparent. Le ou les transducteurs piézoélectriques transparents transforment le signal électrique en vibrations de façon à faire vibrer le substrat transparent et diffuser un signal audible.

L'utilisation d'un substrat transparent comprenant au moins un élément piézoélectrique transparent comme microphone est réalisée par transformation des vibrations du substrat transparent produites sous l'effet d'un signal audible en impulsions électriques destinées à être enregistrées, les vibrations étant transformées en signal électrique par le ou les transducteurs piézoélectriques transparents et transmises au dispositif électronique pour être enregistrées.

L'utilisation d'un substrat transparent comprenant au moins un élément piézoélectrique transparent comme générateur électrique est réalisée par transformation des vibrations du substrat transparent produites sous l'effet de sollicitations mécaniques, par exemple le vent, en électricité, les vibrations étant transformées en un signal électrique par le ou les transducteurs piézoélectriques transparents pour la production d'électricité par le dispositif électronique.

L'invention concerne également un kit comprenant le vitrage isolant et un dispositif électronique adapté à recevoir et analyser un signal émis par le ou les transducteurs piézoélectriques transparents d'un ou plusieurs substrats transparents comprenant au moins un élément piézoélectrique et/ou à envoyer un signal à le ou les transducteurs piézoélectriques transparents d'un ou plusieurs substrats transparents comprenant au moins un élément piézoélectrique de façon à faire vibrer un des substrats transparents du vitrage isolant et/ou à enregistrer un signal électrique émis par le ou les transducteurs piézoélectriques transparents du ou des substrats transparents.

Le dispositif électronique comprend un microcontrôleur relié à une source d'énergie, par exemple au courant de ville.

Un substrat transparent selon l'invention a été réalisé. Une couche piézoélectrique isolante en oxyde de zinc (ZnO) de 1 µm d'épaisseur a été déposée entre deux couches conductrices d'oxyde d'indium-étain (ITO) de 50 nm d'épaisseur sur du verre de 2,1 mm d'épaisseur. La surface du transducteur (surface active du vitrage) est de 5x5 cm². L'application d'une différence de potentiel électrique entre la couche d'ITO supérieure et la couche d'ITO inférieure permet de générer un champ électrique qui déforme la couche de ZnO. Celle-ci sollicite alors le verre. Ce substrat transparent a été utilisé avec succès comme haut-parleur.

## Revendications

1. Substrat transparent (1) comprenant sur au moins une de ses faces au moins un élément piézoélectrique transparent (5), chaque élément piézoélectrique (5) étant situé entre une première et une deuxième électrodes transparentes (6, 7), et chaque élément piézoélectrique (5) et les première et deuxième électrodes transparentes (6, 7) sont sous forme de couches, de façon à former au moins un transducteur piézoélectrique transparent, **caractérisé en ce qu'**au moins une couche diélectrique est disposée entre chaque première et deuxième électrode transparente (6, 7) et le ou les éléments piézoélectriques transparents (5).

2. Substrat transparent (1) selon la revendication 1, dans lequel l'élément piézoélectrique transparent (5) et les première et deuxième électrodes transparentes (6, 7) sont chacun(e) sous forme d'une couche disposée sur toute la surface du substrat transparent et forment un unique transducteur piézoélectrique transparent.

3. Substrat transparent (1) selon la revendication 1, dans lequel le ou les éléments piézoélectriques transparents (5) et les première et deuxième électrodes transparentes (6, 7) sont disposés de façon à former une pluralité de transducteurs piézoélectriques transparents répartis de façon matricielle sur la surface du substrat transparent (1).

4. Substrat transparent (1) selon la revendication 3, comprenant :
- une première électrode transparente (6) sous forme d'une couche disposée sur toute la surface du substrat transparent (1),
- une pluralité d'éléments piézoélectriques transparents (5) sous forme d'une pluralité de portions de couche réparties de façon matricielle sur la surface du substrat transparent (1), les éléments piézoélectriques transparents (5) étant isolés les uns des autres par un matériau isolant (8),
- une pluralité de deuxièmes électrodes transparentes (7) sous forme d'une pluralité de portions de couche réparties de façon matricielle, chaque deuxième électrode transparente (7) étant disposée sur un seul élément piézoélectrique transparent (5).

5. Substrat transparent (1) selon la revendication 3, comprenant :
- une pluralité de premières électrodes transparentes (6) sous forme d'une pluralité de portions de couche réparties de façon matricielle sur la surface du substrat transparent (1),
- un élément piézoélectrique transparent (5) sous forme d'une couche disposée sur toute la surface du substrat transparent (1),
- une deuxième électrode transparente (7) sous forme d'une couche disposée sur toute la surface du substrat transparent (1).

6. Substrat transparent (1) selon la revendication 3, comprenant :
- une pluralité de premières électrodes transparentes (6) sous forme de lignes de couche,
- un élément piézoélectrique transparent (5) sous forme d'une couche disposée sur toute la surface du substrat transparent,
- une pluralité de deuxièmes électrodes transparentes (7) sous forme de lignes de couche.

7. Substrat transparent (1) selon l'une des revendications 1 à 6, dans lequel chaque élément piézoélectrique transparent (5) est en polyfluorure de vinylidène ou en Titano-Zirconate de Plomb dopé au Lanthane (PLZT) ou en oxyde de zinc ou en nitrure d'aluminium ou en copolymère à bloc de poly(styrène-b-isoprène) ou en oxyde de titane et de baryum de type BaTiO₃.

8. Substrat transparent (1) selon l'une des revendications 1 à 7, dans lequel le substrat transparent (1) est en verre organique ou inorganique.

9. Substrat transparent (1) selon l'une des revendications 1 à 8, dans lequel les première et deuxième électrodes transparentes (6, 7) sous forme de couche sont constituées d'un empilement de couches minces comprenant au moins une couche mince en oxyde transparent conducteur et/ou une couche mince métallique et dans lequel chaque élément piézoélectrique transparent (5) est sous forme d'une couche mince.

10. Vitrage isolant comprenant :
- au moins deux substrats transparents espacés deux à deux par une lame de gaz, au moins un des substrats transparents étant selon l'une quelconque des revendications 1 à 9,
- le ou les transducteurs piézoélectriques transparents étant adaptés à être connectés électriquement à un dispositif électronique adapté à recevoir et analyser un signal émis par le ou les transducteurs piézoélectriques transparents soumis à une ou des vibrations et/ou à envoyer un signal à l'élément ou aux transducteurs piézoélectriques transparents de façon à faire vibrer un des substrats transparents.

11. Vitrage isolant selon la revendication 10, dans lequel au moins une face du ou des substrats transparents comprenant au moins un élément piézoélectrique transparent est tournée vers la lame de gaz.

12. Vitrage isolant selon la revendication 10 ou 11, dans lequel, lorsque deux substrats transparents comprennent chacun au moins un élément piézoélectrique transparent ou lorsque les deux faces d'un même substrat comprennent chacune au moins un élément piézoélectrique transparent, le nombre et la répartition des transducteurs piézoélectriques transparents sur la surface des deux substrats transparents ou sur les deux faces du substrat transparent est identique.

13. Utilisation du substrat transparent selon l'une des revendications 1 à 9 ou du vitrage isolant selon l'une des revendications 10 à 12 pour nettoyer de la poussière ou de l'eau sur le ou les substrats transparents comprenant au moins un élément piézoélectrique transparent par envoi d'un signal par le dispositif électronique à le ou les transducteurs piézoélectriques du ou des substrats transparents de façon à faire vibrer le ou les substrats transparents et faire tomber la poussière ou l'eau du ou des substrats transparents.

14. Utilisation du substrat transparent selon l'une des revendications 1 à 9 ou du vitrage isolant selon l'une des revendications 10 à 12 comme haut-parleur par transmission d'un signal par le dispositif électronique à le ou les transducteurs piézoélectriques d'un substrat transparent comprenant au moins un élément piézoélectrique transparent de façon à faire vibrer le substrat transparent et à diffuser un signal audible.

15. Utilisation du substrat transparent selon l'une des revendications 1 à 9 ou du vitrage isolant selon l'une des revendications 10 à 12, comme microphone par transformation des vibrations d'un substrat transparent comprenant au moins un élément piézoélectrique transparent, les vibrations étant produites sous l'effet d'un signal audible et transformées par le ou les transducteurs piézoélectriques en impulsions électriques destinées à être enregistrées.

16. Utilisation du substrat transparent selon l'une des revendications 1 à 9 ou du vitrage isolant selon l'une des revendications 10 à 12 comme générateur électrique par transformation des vibrations d'un substrat transparent comprenant au moins un élément piézoélectrique transparent, les vibrations étant produites sous l'effet de sollicitations mécaniques et transformées par le ou les transducteurs piézoélectriques en un signal électrique pour la production d'électricité.

17. Utilisation du substrat transparent selon l'une des revendications 1 à 9 ou du vitrage isolant selon l'une des revendications 10 à 12 pour atténuer ou, respectivement, amplifier des sons venant de l'extérieur ou de l'intérieur d'un bâtiment sur lequel est posé le substrat transparent ou le vitrage par réception et analyse par un dispositif électronique d'un premier signal émis par le ou les transducteurs piézoélectriques transparents d'un substrat transparent comprenant au moins un élément piézoélectrique transparent et envoi par le dispositif électronique d'un deuxième signal, en opposition de phase ou, respectivement en accord de phase, avec le premier signal, à le ou aux transducteurs piézoélectriques transparents dudit substrat transparent ou à le ou les transducteurs piézoélectriques transparents d'un autre substrat transparent du vitrage dans le cas d'un vitrage comprenant au moins deux substrats transparents comprenant au moins un élément piézoélectrique transparent.

18. Kit comprenant le substrat transparent selon l'une des revendications 1 à 9 ou le vitrage isolant selon l'une des revendications 10 à 12 et un dispositif électronique adapté à recevoir et analyser un signal émis par le ou les transducteurs piézoélectriques transparents d'au moins un substrat transparent comprenant au moins un élément piézoélectrique transparent et/ou à envoyer un signal à le ou les transducteurs piézoélectriques transparents d'au moins un substrat transparent comprenant au moins un élément piézoélectrique transparent de façon à faire vibrer un des substrats transparents du vitrage isolant et/ou à enregistrer un signal électrique émis par le ou les transducteurs piézoélectriques transparents du ou des substrats transparents en réponse à des vibrations du substrat.

## Patentansprüche

1. Transparentes Substrat (1), das auf mindestens einer seiner Flächen mindestens ein transparentes piezoelektrisches Element (5) umfasst, wobei jedes piezoelektrische Element (5) zwischen einer ersten und einer zweiten transparenten Elektrode (6, 7) angeordnet ist und jedes piezoelektrische Element (5) und die erste und die zweite transparente Elektrode (6, 7) die Form von Schichten besitzen, so dass mindestens ein transparenter piezoelektrischer Wandler gebildet wird, **dadurch gekennzeichnet, dass** mindestens eine dielektrische Schicht zwischen jede erste und zweite transparente Elektrode (6, 7) und das oder die piezoelektrische(n) Element(e) (5) eingebracht ist.

2. Transparentes Substrat (1) nach Anspruch 1, wobei das transparente piezoelektrische Element (5) und die erste und die zweite transparente Elektrode (6, 7) jeweils die Form einer Schicht besitzen, die auf der gesamten Oberfläche des transparenten Substrats aufgebracht ist, und einen einzigen transparenten piezoelektrischen Wandler bilden.

3. Transparentes Substrat (1) nach Anspruch 1, wobei das oder die transparente(n) piezoelektrische(n) Element(e) (5) und die erste und die zweite transparente Elektrode (6, 7) so angeordnet sind, dass sie eine Mehrzahl von transparenten piezoelektrischen Wandlern bilden, die gitterförmig auf der Oberfläche des transparenten Substrats (1) verteilt sind.

4. Transparentes Substrat (1) nach Anspruch 3, umfassend:
- eine erste transparente Elektrode (6) in Form einer Schicht, die auf der gesamten Oberfläche des transparenten Substrats (1) aufgebracht ist,
- eine Mehrzahl von transparenten piezoelektrischen Elementen (5) in Form einer Mehrzahl von Schichtanteilen, die gitterförmig auf der Oberfläche des transparenten Substrats (1) verteilt sind, wobei die transparenten piezoelektrischen Elemente (5) voneinander durch ein isolierendes Material (8) isoliert sind,
- eine Mehrzahl von zweiten transparenten Elektroden (7) in Form einer Mehrzahl von Schichtanteilen, die gitterförmig verteilt sind, wobei jede zweite transparente Elektrode (7) auf einem einzigen transparenten piezoelektrischen Element (5) angeordnet ist.

5. Transparentes Substrat (1) nach Anspruch 3, umfassend:
- eine Mehrzahl von ersten transparenten Elektroden (6) in Form einer Mehrzahl von Schichtanteilen, die gitterförmig auf der Oberfläche des transparenten Substrats (1) verteilt sind,
- ein transparentes piezoelektrisches Element (5) in Form einer Schicht, die auf der gesamten Oberfläche des transparenten Substrats (1) aufgebracht ist,
- eine zweite transparente Elektrode (7) in Form einer Schicht, die auf der gesamten Oberfläche des transparenten Substrats (1) aufgebracht ist.

6. Transparentes Substrat (1) nach Anspruch 3, umfassend:
- eine Mehrzahl von ersten transparenten Elektroden (6) in Form von Schichtlinien,
- ein transparentes piezoelektrisches Element (5) in Form einer Schicht, die auf der gesamten Oberfläche des transparenten Substrats aufgebracht ist,
- eine Mehrzahl von zweiten transparenten Elektroden (7) in Form von Schichtlinien.

7. Transparentes Substrat (1) nach einem der Ansprüche 1 bis 6, wobei jedes transparente piezoelektrische Element (5) aus Vinylidenfluorid oder aus mit Lanthan dotiertem Blei-Zirkonat-Titanat (PLZT) oder aus Zinkoxid oder aus Aluminiumnitrid oder aus einem Poly(styrol-b-isopren)-Blockcopolymer oder aus Titan- und Bariumoxid des Typs BaTiO₃ besteht.

8. Transparentes Substrat (1) nach einem der Ansprüche 1 bis 7, wobei das transparente Substrat (1) aus organischem oder anorganischem Glas besteht.

9. Transparentes Substrat (1) nach einem der Ansprüche 1 bis 8, wobei die erste und die zweite transparente Elektrode (6, 7) in Schichtform aus einem Stapel von Dünnschichten bestehen, der mindestens eine Dünnschicht aus transparentem leitendem Oxid und/oder eine metallische Dünnschicht umfasst, und wobei jedes transparente piezoelektrische Element (5) die Form einer Dünnschicht aufweist.

10. Isolierverglasung, umfassend:
- mindestens zwei transparente Substrate, die jeweils paarweise durch eine Gasschicht voneinander beabstandet sind, wobei mindestens eines der transparenten Substrate nach einem der Ansprüche 1 bis 9 ist,
- den oder die transparenten piezoelektrischen Wandler, der/die dafür ausgelegt ist/sind, elektrisch mit einer elektronischen Vorrichtung verbunden zu werden, die dafür ausgelegt ist, ein Signal zu empfangen und zu analysieren, das von dem oder den transparenten piezoelektrischen Wandler(n) ausgesendet wird, der/die einer oder Vibration(en) ausgesetzt wird/werden, und/oder ein Signal an das Element oder an die piezoelektrischen transparenten Wandler zu senden, um eines der transparenten Substrate vibrieren zu lassen.

11. Isolierverglasung nach Anspruch 10, wobei mindestens eine Fläche des transparenten Substrats oder der transparenten Substrate, die mindestens ein transparentes piezoelektrisches Element umfasst, der Gasschicht zugewandt ist.

12. Isolierverglasung nach Anspruch 10 oder 11, wobei, wenn zwei transparente Substrate jeweils mindestens ein transparentes piezoelektrisches Element umfassen oder wenn die beiden Flächen desselben Substrats jeweils mindestens ein transparentes piezoelektrisches Element umfassen, die Anzahl und die Verteilung der transparenten piezoelektrischen Wandler auf der Oberfläche der zwei transparenten Substrate oder auf den beiden Flächen des transparenten Substrats jeweils die gleiche ist.

13. Verwendung des transparenten Substrats nach einem der Ansprüche 1 bis 9 oder der Isolierverglasung nach einem der Ansprüche 10 bis 12 zum Entfernen von Staub oder Wasser auf dem oder den transparenten Substrat(en), das/die mindestens ein transparentes piezoelektrisches Element umfasst/umfassen, durch Senden eines Signals von der elektronischen Vorrichtung an den oder die piezoelektrischen Wandler des transparenten Substrats oder der transparenten Substrate derart, dass man das oder die transparente(n) Substrat(e) vibrieren und den Staub oder das Wasser von dem oder den transparenten Substrat(en) abfallen lässt.

14. Verwendung des transparenten Substrats nach einem der Ansprüche 1 bis 9 oder der Isolierverglasung nach einem der Ansprüche 10 bis 12 als Lautsprecher durch Übertragung eines Signals von der elektronischen Vorrichtung an den oder die piezoelektrischen Wandler eines transparenten Substrats, das mindestens ein transparentes piezoelektrisches Element umfasst, derart, dass man das transparente Substrat schwingen und ein hörbares Signal ausstrahlen lässt.

15. Verwendung des transparenten Substrats nach einem der Ansprüche 1 bis 9 oder der Isolierverglasung nach einem der Ansprüche 10 bis 12 als Mikrophon durch Umwandeln von Vibrationen eines transparenten Substrats, das mindestens ein transparentes piezoelektrisches Element umfasst, wobei die Vibrationen unter der Wirkung eines hörbaren Signals erzeugt und von dem oder den piezoelektrischen Wandler(n) in aufzuzeichnende elektrische Impulse umgewandelt werden.

16. Verwendung des transparenten Substrats nach einem der Ansprüche 1 bis 9 oder der Isolierverglasung nach einem der Ansprüche 10 bis 12 als elektrischer Generator durch Umwandeln von Vibrationen eines transparenten Substrats, das mindestens ein transparentes piezoelektrisches Element umfasst, wobei die Vibrationen unter der Wirkung mechanischer Belastungen erzeugt und von dem oder den piezoelektrischen Wandler(n) in ein elektrisches Signal zur Erzeugung von Elektrizität umgewandelt werden.

17. Verwendung des transparenten Substrats nach einem der Ansprüche 1 bis 9 oder der Isolierverglasung nach einem der Ansprüche 10 bis 12 zum Abschwächen bzw. Verstärken von Tönen, die von außerhalb oder innerhalb eines Gebäudes kommen, auf das das transparente Substrat oder die Verglasung aufgebracht ist, indem von einer elektronischen Vorrichtung ein erstes Signal empfangen und analysiert wird, das von dem oder den transparenten piezoelektrischen Wandler(n) eines transparenten Substrats, das mindestens ein transparentes piezoelektrisches Element umfasst, ausgesendet wird, und von der elektronischen Vorrichtung ein zweites Signal in Gegenphase zu bzw. in Phasenanpassung mit dem ersten Signal an den oder die transparenten piezoelektrischen Wandler des transparenten Substrats oder an den oder die transparenten piezoelektrischen Wandler eines anderen transparenten Substrats der Verglasung im Fall einer Verglasung, die mindestens zwei transparente Substrate umfasst, die mindestens ein transparentes piezoelektrisches Element umfassen, gesendet wird.

18. Bausatz, umfassend das transparente Substrat nach einem der Ansprüche 1 bis 9 oder die Isolierverglasung nach einem der Ansprüche 10 bis 12 und eine elektronische Vorrichtung, sie dafür ausgelegt ist, ein von dem oder den transparenten piezoelektrischen Wandler(n) mindestens eines transparenten Substrats, das mindestens ein transparentes piezoelektrisches Element umfasst, ausgesendetes Signal zu empfangen und zu analysieren und/oder ein Signal an den oder die transparenten piezoelektrischen Wandler mindestens eines transparenten Substrats, das mindestens ein transparentes piezoelektrisches Element umfasst, zu senden, derart, dass man eines der transparenten Substrate der Isolierverglasung vibrieren lässt, und/oder ein elektrisches Signal, das von dem oder den transparenten piezoelektrischen Wandler(n) des transparenten Substrats oder der transparenten Substrate als Reaktion auf die Vibrationen des Substrats ausgesendet wird, aufzuzeichnen.

## Claims

1. A transparent substrate (1) comprising on at least one of its faces at least one transparent piezoelectric element (5), each piezoelectric element (5) being located between a first and a second transparent electrode (6, 7), and each piezoelectric element (5) and the first and second transparent electrodes (6, 7) taking the form of films, so as to form at least one transparent piezoelectric transducer, **characterized in that** at least one dielectric film is placed between each first and second transparent electrode (6, 7) and the one or more transparent piezoelectric elements (5).

2. The transparent substrate (1) as claimed in claim 1, in which the transparent piezoelectric element (5) and the first and second transparent electrodes (6, 7) each take the form of a film placed over the entire surface of the transparent substrate and form a single transparent piezoelectric transducer.

3. The transparent substrate (1) as claimed in claim 1, in which the one or more transparent piezoelectric elements (5) and the first and second transparent electrodes (6, 7) are placed so as to form a plurality of transparent piezoelectric transducers distributed in a matrix over the surface of the transparent substrate (1).

4. The transparent substrate (1) as claimed in claim 3, comprising:
- a first transparent electrode (6) taking the form of a film placed over the entire surface of the transparent substrate (1);
- a plurality of transparent piezoelectric elements (5) taking the form of a plurality of film portions distributed in a matrix over the surface of the transparent substrate (1), the transparent piezoelectric elements (5) being isolated from one another by an insulator (8); and
- a plurality of second transparent electrodes (7) taking the form of a plurality of film portions distributed in a matrix, each second transparent electrode (7) being placed on a single transparent piezoelectric element (5).

5. The transparent substrate (1) as claimed in claim 3, comprising:
a plurality of first transparent electrodes (6) taking the form of a plurality of film portions distributed in a matrix over the surface of the transparent substrate (1);
- a transparent piezoelectric element (5) taking the form of a film placed over the entire surface of the transparent substrate (1); and
- a second transparent electrode (7) taking the form of a film placed over the entire surface of the transparent substrate (1).

6. The transparent substrate (1) as claimed in claim 3, comprising:
- a plurality of first transparent electrodes (6) taking the form of lines of film;
- a transparent piezoelectric element (5) taking the form of a film placed over the entire surface of the transparent substrate; and
- a plurality of second transparent electrodes (7) taking the form of lines of film.

7. The transparent substrate (1) as claimed in one of claims 1 to 6, in which each transparent piezoelectric element (5) is made of polyvinylidene fluoride or lead lanthanum zirconate titanate (PLZT) or of zinc oxide or of aluminum nitride or poly(styrene-b-isoprene) block copolymer or of barium titanate (BaTiO₃).

8. The transparent substrate (1) as claimed in one of claims 1 to 7, in which the transparent substrate (1) is made of organic or mineral glass.

9. The transparent substrate (1) as claimed in one of claims 1 to 8, in which the first and second transparent electrodes (6, 7) taking the form of films consist of a thin-film multilayer comprising at least one thin transparent conductive oxide film and/or one thin metal film and in which each transparent piezoelectric element (5) takes the form of a thin film.

10. An insulating glazing unit comprising:
- at least two transparent substrates spaced apart pairwise by a gas-filled cavity, at least one of the transparent substrates being as claimed in any one of claims 1 to 9,
- the one or more transparent piezoelectric transducers being able to be electrically connected to an electronic device able to receive and analyze a signal emitted by the one or more transparent piezoelectric transducers when subjected to one or more vibrations and/or to transmit a signal to the element or to the transparent piezoelectric transducers so as to make one of the transparent substrates vibrate.

11. The insulating glazing unit as claimed in claim 10, in which at least one face of the one or more transparent substrates comprising at least one transparent piezoelectric element is oriented toward the gas-filled cavity.

12. The insulating glazing unit as claimed in either of claims 10 and 11, in which, when two transparent substrates each comprise at least one transparent piezoelectric element or when both faces of a given substrate each comprise at least one transparent piezoelectric element, the number and the distribution of the transparent piezoelectric transducers over the surface of the two transparent substrates or over both faces of the transparent substrate is identical.

13. The use of the transparent substrate as claimed in one of claims 1 to 9 or of the insulating glazing unit as claimed in one of claims 10 to 12 to remove dust or water from the one or more transparent substrates comprising at least one transparent piezoelectric element by transmitting a signal from the electronic device to the one or more piezoelectric transducers of the one or more transparent substrates in order to make the one or more transparent substrates vibrate and make the dust or water fall from the one or more transparent substrates.

14. The use of the transparent substrate as claimed in one of claims 1 to 9 or of the insulating glazing unit as claimed in one of claims 10 to 12 as a loudspeaker, a signal being transmitted from the electronic device to the one or more piezoelectric transducers of a transparent substrate comprising at least one transparent piezoelectric element so as to make the transparent substrate vibrate and produce an audible signal.

15. The use of the transparent substrate as claimed in one of claims 1 to 9 or of the insulating glazing unit as claimed in one of claims 10 to 12 as a microphone, the vibration of a transparent substrate comprising at least one transparent piezoelectric element, the vibration being produced under the effect of an audible signal, being converted by the one or more piezoelectric transducers into electrical pulses that are intended to be recorded.

16. The use of the transparent substrate as claimed in one of claims 1 to 9 or of the insulating glazing unit as claimed in one of claims 10 to 12 as an electrical generator, vibration of a transparent substrate comprising at least one transparent piezoelectric element, the vibration being produced under the effect of mechanical forces, being converted by the one or more piezoelectric transducers into an electrical signal for the production of electricity.

17. The use of the transparent substrate as claimed in one of claims 1 to 9 or of the insulating glazing unit as claimed in one of claims 10 to 12 to attenuate or amplify, respectively, sounds coming from the exterior or from the interior of a building in which the transparent substrate or the glazing unit is fitted, an electronic device receiving and analyzing a first signal emitted by the one or more transparent piezoelectric transducers of a transparent substrate comprising at least one transparent piezoelectric element, said electronic device transmitting a second signal that is in phase opposition to or phase matched with the first signal, respectively, to the one or more transparent piezoelectric transducers of said transparent substrate or to the one or more transparent piezoelectric transducers of another transparent substrate of the glazing unit in the case of a glazing unit comprising at least two transparent substrates comprising at least one transparent piezoelectric element.

18. A kit comprising the transparent substrate as claimed in one of claims 1 to 9 or the insulating glazing unit as claimed in one of claims 10 to 12 and an electronic device able to receive and analyze a signal emitted by the one or more transparent piezoelectric transducers of at least one transparent substrate comprising at least one transparent piezoelectric element and/or to transmit a signal to the one or more transparent piezoelectric transducers of at least one transparent substrate comprising at least one transparent piezoelectric element so as to make one of the transparent substrates of the insulating glazing unit vibrate and/or to record an electrical signal emitted by the one or more transparent piezoelectric transducers of the one or more transparent substrates in response to vibration of the substrate.
